**Europäisches Patentamt**

**European Patent Office**

**Office européen des brevets**

(11) Veröffentlichungsnummer: **0 338 447**
**A2**

## (12) EUROPÄISCHE PATENTANMELDUNG

(21) Anmeldenummer: **89106709.2**

(22) Anmeldetag: **14.04.89**

(51) Int. Cl.⁴: **H05K 7/20 , H05K 3/22**

(30) Priorität: **21.04.88 DE 3813364**

(43) Veröffentlichungstag der Anmeldung:
**25.10.89 Patentblatt 89/43**

(84) Benannte Vertragsstaaten:
**CH DE FR GB IT LI NL**

(71) Anmelder: **Bodenseewerk Gerätetechnik GmbH**
**Alte Nussdorfer Strasse 15 Postfach 1120**
**D-7770 Überlingen/Bodensee(DE)**

(72) Erfinder: **Ohlenburger, Hans**
**Dahlienweg 8**
**D-7770 Überlingen(DE)**

(74) Vertreter: **Weisse, Jürgen, Dipl.-Phys. et al**
**Patentanwälte Dipl.-Phys. Jürgen Weisse**
**Dipl.-Chem. Dr. Rudolf Wolgast Bökenbusch**
**41 Postfach 11 03 86**
**D-5620 Velbert 11 Langenberg(DE)**

(54) **Vorrichtung zur Wärmeabfuhr von Bauelementen auf einer Leiterplatte.**

(57) Zur Wärmeabfuhr von auf einer Leiterplatte montierten Bauelementen ist auf die Leiterplatte (10) eine Kupferschicht (14) aufgebracht und auf diese Kupferschicht (14) eine Schicht (16) aus Reinaluminium aufgavanisiert. Die Leiterplatte (10) ist auf beiden Seiten mit Kupfer-und Reinaluminiumschichten (14,16) versehen, wobei die Bauelemente (12) jeweils auf einer solchen Kupfer- und Reinaluminiumschicht montiert sind. Die Leiterplatte (10) weist im Bereich der Bauelemente (12) Bohrungen (22) auf. Die Kupfer- und Reinaluminiumschicht (14, 16) erstreckt sich über die Innenwandung der Bohrung (22), so daß eine Verbindung (24) zwischen der mit dem Bauelement (12) in Kontakt befindlichen Kupfer- und Reinaluminiumschicht (14,16) und der Kupfer- und Reinaluminiumschicht auf der gegenüberliegenden Seite der Leiterplatte (10) hergestellt ist. Die aufgavanisierte Reinaluminiumschicht (16) ist im Bereich der Bauteile (12) zur Erzielung einer planen Oberfläche mechanisch bearbeitet. In der Kupfer- und Reinaluminiumschicht (14,16) sind Bereiche (18) ausgespart, in denen Lötanschlüsse (20) und Leiterbahnen angeordnet sind.

Fig.1

## Vorrichtung zur Wärmeabfuhr von Bauelementen auf einer Leiterplatte

### Technisches Gebiet

Die Erfindung betrifft eine Einrichtung zur Wärmeabfuhr von auf einer Leiterplatte montierten Bauelementen, bei welcher auf die Leiterplatte eine Kupferschicht aufgebracht ist, auf welche wiederum eine weitere Schicht aufgebracht ist.

### Zugrundeliegender Stand der Technik

Eine Einrichtung zur Wärmeabfuhr von Leiterplatten ist bekannt durch die DE-A1-33 31 112. Dabei sind auf einer Seite der Leiterplatte elektrische Bauteile angeordnet. Auf der Seite, auf welcher die Bauteile sitzen, ist auf die Leiterplatte eine gut wärmeleitende Schicht aufgebracht. Die DE-A1-33 31 112 beschreibt Maßnahmen zur Ableitung der Wärme von dieser Schicht. Die Schicht ist dort ein Wärmeleitblech, das an der Leiterplatte angebracht ist.

Durch die DE-A1-30 35 749 ist eine wärmeableitende, plane Leiterplatte mit einem Kern aus metallischen Werkstoffen bekannt, die mit einer Kupferschicht überzogen ist, welche ihrerseits eine Galvanoaluminiumeloxalschicht trägt. Die Galvanoaluminiumeloxalschicht ist mit einer Kunststoffschicht überzogen. Die Galvanoaluminiumeloxalschicht trägt Leiterbahnen.

Bei der Herstellung wird Aluminium auf die Kupferschicht aufgalvanisiert. Die so erhaltene Aluminiumschicht wird dann durch weitere Behandlung in Galvanoaluminiumeloxal umgewandelt.

Die Wärmeableitung erfolgt hier im wesentlichen über den metallischen Kern der Leiterplatte. Die Leiterplatte mit einem solchen metallischen Kern wird jedoch unerwünscht schwer. Leiterplatten aus leitfähigem Kohlenstoff oder Graphit sind aufwendig. Die Galvanoaluminiumeloxalschicht bildet einen Isolator und gewährleistet keine gute Wärmeleitung in der Ebene der Leiterplatte.

Bei der DE-A1-30 35 749 sind in den Leiterplatten Bohrungen vorgesehen. Diese dienen dazu, Leiterbahnen von einer Seite der Leiterplatte zur anderen durchzuverbinden. Die Bohrungen haben nicht die Funktion, Wärme von einem Bauteil zu einer wärmeableitenden Schicht auf der anderen Seite der Leiterplatte abzuleiten.

Die DE-A1-31 15 017 zeigt ein elektronisches Bauelement in Form einer integrierten Schaltung, das mit einer Trägerplatte auf einer Leiterplatte sitzt. Die Auflagefläche der Trägerplatte auf der Leiterplatte ist wärmeleitend metallisiert. In der Leiterplatte sind im Bereich des Bauteils metallisierte Löcher angebracht. Über diese metalliusierten Löcher ist die Trägerplatte mit einer Kühlplatte auf der Rückseite der Leiterplatte wärmeleitend verbunden. Bei dieser Anordnung ist jedem Bauteil eine Kühlplatte zugeordnet, die ein von der Leiterplatte getrennter Teil ist.

### Offenbarung der Erfindung

Der Erfindung liegt die Aufgabe zugrunde, die Wärmeabfuhr von Leiterplatten der eingangs genannten Art mit möglichst geringem Aufwand zu verbessern.

Erfindungsgemäß wird diese Aufgabe dadurch gelöst, daß die auf die Kupferschicht aufgebrachte weitere Schicht aus Reinaluminium besteht.

Es wird somit als gut wärmeleitende Schicht eine Schicht aus Reinaluminium benutzt. Reinaluminium ist ein guter Wärmeleiter. Es ist weiterhin sehr leicht. Daher kann eine relativ dicke Schicht aufgebracht werden, was die Wärmeableitung verbessert. Dieses Aufbringen geschieht in der Weise, daß zunächst eine Kupferschicht auf die Leiterplatte aufgebracht wird. Das kann in dem gewünschten Muster mit bekannten Techniken geschehen. Auf diese Kupferschicht wird das Reinaluminium durch Galvanisieren aufgebracht. Dabei kann die Schicht in einem Muster aufgebracht werden, das durch das Muster der Kupferschicht vorgegeben ist. Es kann daher auf einfache Weise eine dicke Schicht von Reinaluminium auf die Leiterplatte aufgebracht werden.

Ein guter Wärmeübergang von den auf der Leiterplatte angeordneten Bauteilen zu der wärmeableitenden Schicht ergibt sich dadurch, daß

(a) die Leiterplatte auf beiden Seiten mit Kupfer- und Reinaluminiumschichten versehen ist, wobei die Bauelemente jeweils auf einer solchen Kupfer- und Reinaluminiumschicht montiert sind,

(b) die Leiterplatte im Bereich der Bauelemente Bohrungen aufweist und

(c) die Kupfer- und Reinaluminiumschicht sich über die Innenwandung der Bohrung erstreckt so daß eine Verbindung zwischen der mit dem Bauelement in Kontakt befindlichen Kupfer- und Reinaluminiumschicht und der Kupfer- und Reinaluminiumschicht auf der gegenüberliegenden Seite der Leiterplatte hergestellt ist.

Eine weitere Verbesserung des Wärmeüberganges von den Bauteilen auf die Reinaluminiumschicht ergibt sich dadurch, daß die aufgalvanisierte Reinaluminiumschicht im Bereich der Bauteile zur Erzielung einer planen Oberfläche mechanisch bearbeitet ist.

In der Kupfer- und Reinaluminiumschicht können Bereiche ausgespart sein, in denen Lötanschlüsse und Leiterbahnen angeordnet sind.

Es wird also als wärmeableitende Schicht ein sich über praktisch die gesamte Oberfläche der Leiterplatte erstreckender Überzug aus Reinaluminium vorgesehen. Das ist fertigungstechnisch günstig und liefert eine gute Wärmeableitung. Allerdings ist Reinaluminium auch elektrisch gut leitend. Daher können die Leiterbahnen nicht auf die Reinaluminiumschicht aufgebracht werden. Dieses Problem wird dadurch gelöst, daß die Reinaluminiumschicht Aussparungen aufweist, in denen die Leiterbahnen und Lötanschlüsse der Bauteile angeordnet sind.

Ein Ausführungsbeispiel der Erfindung ist nachstehend unter Bezugnahme auf die zugehörigen Zeichnungen näher erläutert.

## Kurze Beschreibung der Zeichnungen

Fig.1 zeigt schematisch einen Schnitt durch eine Leiterplatte mit gut wärmeleitender Schicht und einem auf der Leiterplatte angeordneten elektrischen Bauteil

Fig.2 zeigt in vergrößertem Maßstab einen durch den gestrichelten Kreis II in Fig. 1 bezeichneten Ausschnitt von Fig. 1.

## Bevorzugte Ausführung der Erfindung

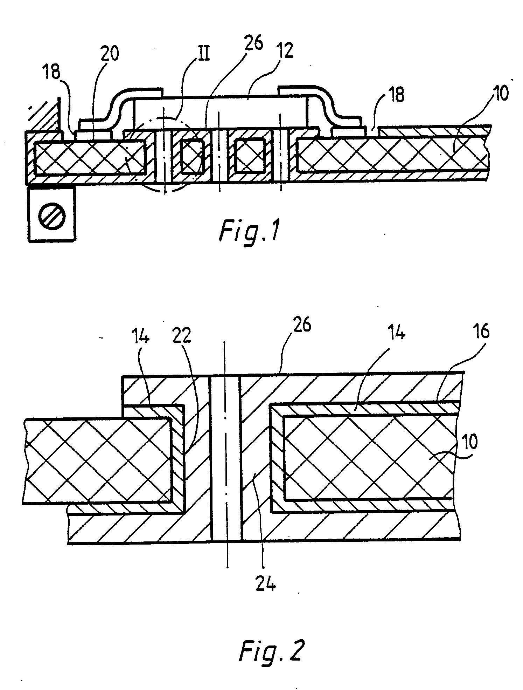

In Fig.1 und 2 ist mit 10 eine Leiterplatte bezeichnet. Die Leiterplatte 10 trägt elektrische und elektronische Bauteile, von denen in Fig.1 ein Bauteil 12 dargestellt ist. Wie aus Fig.2 deutlicher erkennbar ist, ist auf die Leiterplatte 10 eine Kupferschicht 14 aufgebracht. Auf diese Kupferschicht ist eine ziemlich dicke Reinaluminiumschicht 16 aufgalvanisiert. Die Kupferschicht 14 und die Reinaluminiumschicht 16 ist sowohl auf der in Fig.1 oberen Seite, wo die Bauteile 12 montiert sind, als auch auf der in Fig.1 unteren Seite vorgesehen. In der Kupfer- und Reinaluminiumschicht 14 bzw. 16 sind Bereiche 18 ausgespart, in denen auf der Leiterplatte 10 Lötanschlüsse 20 oder Leiterbahnen angebracht sind. Der Bauteil 12 sitzt auf der Oberfläche der Reinaluminiumschicht 16.

Die Leiterplatte 10 weist im Bereich der Bauteile 12 Bohrungen 22 auf. Die Innenwandungen der Bohrungen 22 sind ebenfalls mit der Kupferschicht 14 und darüber mit der Reinaluminiumschicht 16 beschichtet. Dadurch entsteht eine gut wärmeleitende Verbindung 24 zwischen der in Fig.1 oberen Reinaluminiumschicht 16, mit welcher der Bauteil 12 in Kontakt ist, und der Reinaluminiumschicht auf der Unterseite der Leiterplatte 10. Auf diese Weise wird eine gute Wärmeableitung von dem Bauteil 12 zu der auf der gegenüberliegenden Reinaluminiumschicht erzielt.

Die Oberfläche 26 der Reinaluminiumschicht 16 in dem Bereich, in welchem der Bauteil 12 angeordnet ist, wird mechanisch bearbeitet, um eine gut plane Fläche zu erhalten. Dadurch ist ein enger Kontakt zwischen Bauteil 12 und Reinaluminiumschicht 16 gewährleistet, der ebenfalls die Wärmeableitung begünstigt.

Die Schichtdicke der Kupferschicht liegt in der Größenordnung von Mikrometern ($\mu$), während die Schichtdicke der Reinaluminiumschicht bis zu einem Millimeter betragen kann.

Das Material der Leiterplatte ist konventionell und kann beispielsweise Epoxidharz sein.

## Ansprüche

1. Einrichtung zur Wärmeabfuhr von auf einer Leiterplatte montierten Bauelementen, bei welcher auf die Leiterplatte eine Kupferschicht aufgebracht ist, auf welche wiederum eine weitere Schicht aufgebracht ist, **dadurch gekennzeichnet, daß** die auf die Kupferschicht aufgebrachte weitere Schicht aus Reinaluminium besteht.

2. Einrichtung nach Anspruch 1, **dadurch gekennzeichnet, daß**

(a) die Leiterplatte (10) auf beiden Seiten mit Kupfer- und Reinaluminiumschichten (14,16) versehen ist, wobei die Bauelemente (12) jeweils auf einer solchen Kupfer- und Reinaluminiumschicht montiert sind,

(b) die Leiterplatte (10) im Bereich der Bauelemente (12) Bohrungen (22) aufweist und

(c) die Kupfer- und Reinaluminiumschicht (14,16) sich über die Innenwandung der Bohrung (22) erstreckt so daß eine Verbindung (24) zwischen der mit dem Bauelement (12) in Kontakt befindlichen Kupfer-und Reinaluminiumschicht (14,16) und der Kupfer-und Reinaluminiumschicht auf der gegenüberliegenden Seite der Leiterplatte (10) hergestellt ist.

3. Einrichtung nach Anspruch 2, **dadurch gekennzeichnet, daß** die aufgalvanisierte Reinaluminiumschicht (16) im Bereich der Bauteile (12) zur Erzielung einer planen Oberfläche mechanisch bearbeitet ist.

4. Einrichtung nach Anspruch 2 oder 3, **dadurch gekennzeichnet, daß** in der Kupfer- und Reinaluminiumschicht (14,16) Bereiche (18) ausgespart sind, in denen Lötanschlüsse (20) und Leiterbahnen angeordnet sind.

Fig.1

Fig. 2